# EUROPEAN PATENT SPECIFICATION

(11) **EP 1 017 874 B1**
(45) Date of publication and mention of the grant of the patent: **20.02.2002**
(21) Application number: 98931739.1
(22) Date of filing: 30.06.1998
(51) Int. Cl.: C23C 16/26

(54) **COLORLESS DIAMOND-LIKE CARBON COATINGS**
FARBLOSE DIAMANTÄHNLICHE KOHLENSTOFFBESCHICHTUNGEN
REVETEMENTS EN CARBONE SEMBLABLE A DU DIAMANT NON COLORE

(30) Priority: 01.07.1997 US 51372 P
(43) Date of publication of application: 12.07.2000
(73) Proprietor: E.I. DU PONT DE NEMOURS AND COMPANY, Wilmington Delaware 19898 (US)
(72) Inventor: COATES, Don, Mayo, Santa Fe, NM 87501 (US)
(74) Representative: Jones, Alan John
(86) International application number: US9813603
(87) International publication number: WO9901589

(56) References cited:
- EP-A- 0 454 995
- EP-A- 0 668 372
- EP-A- 0 676 484
- US-A- 4 783 361
- US-A- 5 145 711

## Description

### FIELD OF THE INVENTION

The invention generally relates to a process for producing essentially colorless diamond-like carbon coatings on substrates. In particular, the invention relates to producing such coatings on plastic substrates used for automotive and aircraft windows.

### BACKGROUND OF THE INVENTION

Newly proposed automotive safety standards for side impact protection increase the need for plastic side windows for automotive applications. Currently used glass windows do not do an adequate job in preventing passenger ejection during side impacts. In addition to the improved safety of plastic windows, plastic is lighter and has superior sound insulation qualities.

Aircraft manufacturers are also very interested in improving their plastic windows. Scratch and impact resistance are key issues. Such coatings must also be inert to and protect the plastic from sulfuric acid which is present in high altitude air pollution.

The short lifetime of current silicon-based anti-scratch technology has prevented the use of plastic windows in automotive applications. Aircraft sensitivities to weight and impact resistance have forced that industry to use plastic in some windows but they have high replacement rates because excess scratching makes visibility unacceptable.

Diamond-like carbon (DLC) coatings on optical plastics have been demonstrated. DLC provides excellent scratch resistance and is a barrier to chemical attack. DLC-coated plastic lenses for sun glasses have been available commercially for some time. However, since the usual DLC coating is typically a tan to dark brown color, DLC has been used only in those optical applications that do not require colorless coatings.

Clearly, there is a need for a process to produce essentially colorless, clear DLC-based coatings and for the resulting coatings themselves. Other objects and advantages of the present invention will become apparent to those skilled in the art upon reference to the detailed description which hereinafter follows.

### SUMMARY OF THE INVENTION

This invention provides a process for producing an essentially colorless, clear low-conjugation DLC coating on a substrate, comprising:
(a) depositing a thin layer of DLC onto a substrate;
(b) contacting the deposited DLC with a reactive species capable of saturating the double bonds in the DLC to produce low conjugation-DLC;
(c) depositing a thin layer of DLC onto the surface of the low conjugation-DLC;
(d) contacting the DLC deposited in step (c) with a reactive species capable of saturating the double bonds in the DLC to produce low conjugation-DLC; and
(e) repeating steps (c) and (d) until a coating of low conjugation-DLC of the desired thickness has been produced.
The thickness of each thin layer of DLC deposited is preferably 0.1 µm or less and the thickness of the low conjugation-DLC (1c-DLC) coating is preferably 10 µm or less. The reactive species is preferably in a gaseous state and preferably an activated form of a halogen, i.e., fluorine, chlorine or bromine, or of hydrogen. If the desired thickness of the essentially colorless, clear low conjugation-DLC is 0.1 µm or less, the process can comprise step (a) in which a layer of DLC of the desired thickness is deposited and step (b).

### DETAILED DESCRIPTION OF THE INVENTION

DLC is a blend of sp2 and sp3 bonded carbon. The sp3 bond, which is present in true diamond, is a single bond and there are no light absorption bands in the visible spectrum associated with it. Such single bonds exhibit absorption in the UV region of the electromagnetic spectrum. In contrast, the sp2 bonded carbon which occurs in graphite, is a double bond and hence has electrons which are more mobile and can interact with electromagnetic radiation at lower energies. Double bonds are interactive in the visible spectrum when a sufficient number of bonds are conjugated together. For example, graphite is black and opaque, even in very thin compositions, because of the extensive conjugated network of double bonds. DLC has a much less extensive conjugated network than graphite and is typically clear in thin coatings, i.e., coatings with thickness less than about 1 µm, although there is typically a light tan color associated therewith. In thick coatings, i.e., coatings with thickness greater than about 5 µm, DLC is opaque with a dark brown to nearly black color. Most optical grade window anti-scratch coatings are preferably clear and colorless so that tinting can be added as desired.

The process of this invention relates to saturating double bonds in DLC, i.e., to the conversion of the double bonds to single bonds, and to thereby lower the conjugation. This is accomplished by chemical addition, i.e., by contacting a reactive species with DLC during and/or between the deposition of thin layers of DLC and results in low conjugation-DCL (1c-DCL). An example of such a reaction is shown in Equation 1, wherein the reactive species "X*" reacts and removes the double bond: 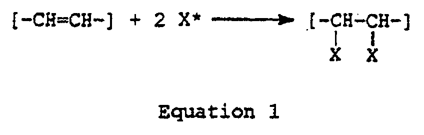 The reactive species "X*" is preferably in a gaseous state. The reactive species is one that can react with the double bond and is preferably an activated form of a halogen, i.e., fluorine, chlorine or bromine, or of hydrogen. The initial precursor ground state sources of these activated species would typically be from gases such as the diatomic gases F₂, Cl₂ and H₂ or gases in which the species is combined with other elements, e.g. CF₄, SF₆ and CCl₄. Examples of generation of active species are given below in Equations 2 and 3. 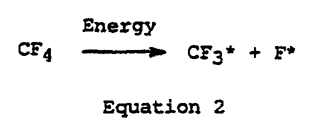 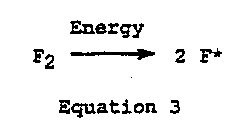 The energy applied can be, among others, electromagnetic or thermal.

In one embodiment of the process of the invention, the reactive species F* is reacted with the sp2 bonds during "bleaching" cycles in which double bonds are saturated between repeated steps of depositions of DLC on a substrate. A thin layer, i.e., 0.1 µm or less in thickness, of DLC is deposited in each deposition step by any of a number of well known DLC deposition technologies available in the art, e.g., by chemical vapor deposition (CVD), laser ablation, ion beam ablation, plasma torch, cathodic arc, etc. Various CVD techniques are disclosed in P. K. Bachman et al., Diamond and Related Materials, 1, 1 (1991). Of these, a CVD technology using RF excitation and an ion implantation technique known as plasma source ion implantation (PSII) can be conveniently used in the process. The deposition step is stopped and the "bleaching" step initiated. A plasma of reactive species X* can be created by energy input, such as radio frequency excitation at 13.56 MHz, and the resulting species allowed to react with sp2 bonds in the thin DLC layer. The X* species could be deliberately generated in the form of an ion and "driven" into the DLC coating by known ion implantation techniques. The "bleaching" step is then stopped, and the cycle of deposition and "bleaching" continued until the desired coating thickness is achieved.

The thickness of the layer of DLC to be "bleached" must be sufficiently thin to allow the effective diffusion of the active species X* into the DLC. The alternating steps of DLC deposition and "bleaching" are performed within the process chamber so as to ensure that the DLC layer is thin enough, i.e., 0.1 µm or less in thickness, so that effective diffusion of the active species X* into the DLC occurs. Otherwise, only the portion of the DLC near the surface would be de-colorized.

The alternation of steps, for example, can conveniently be achieved when using a CVD deposition process by manifolding the process gases and having high speed valving controlling switching back and forth from deposition gases (e.g., methane, acetylene, etc.) to "bleaching" gases. In the case of ablation deposition technologies using cathodic arc, laser beam, or ion beam ablation, the "bleaching" gases can be puffed over the DLC substrate between ablated plumes of carbon. High speed valving technology is available commercially. The frequency of the alternation of the deposition and "bleaching" will depend on the manifolding and proximity to the substrate so as to allow appropriate diffusion time and separation of the deposition and "bleaching" steps. However, cycle times of 10-100 Hertz should be readily achievable.

The process of the invention produces essentially colorless, clear Ic-DLC coatings. By "essentially colorless, clear low conjugation DLC coatings" is meant coatings of thickness up to 10 µm which absorb less than 20% of the incident light of any wavelength in the visible spectrum, i.e., any wavelength in the range of 400 nm to 700 nm.

It is expected that the essentially colorless, clear 1c-DLC coatings made by the process of this invention will be useful for applications other than those based on optical properties (i.e., beyond automotive and aircraft windows). For example, it is expected that the electrical resistance, electrical breakdown strength and dielectric constant properties will also be impacted by removal of the double bond color sites since such sites are mechanistically related to these electrical properties. Electrical resistance and breakdown strength will be raised. Use of DLC for the interlayer dielectric insulator in integrated circuits has been considered. The 1c-DLC produced with the process of this invention will have a lower dielectric constant and thus be more desirable for integrated circuits insulator applications.

It is also expected that the DLC coatings of the invention may be applied in a patterned manner to the window leaving some areas uncoated. This may be important so that uncoated attachment areas (e.g., glue areas) are available to attach the window to lift mechanisms. It may also be preferable to leave any areas that contain heating wires or elements in the window uncoated.

DLC coatings may be applied over previously-applied SiOₓ hard coatings on the window substrate. This may help provide a graded modulus interface between the DLC coating and the window substrate. The SiOₓ interface may aid in the adhesion of the DLC coating, especially when thickly applied.

For plastic windows, laminated structures may be made by a number of means. For example, co-extrusion, roller lamination or the use of an adhesive, interfacial film layer (e.g., "BUTACITE" film commercially available from E. I. du Pont de Nemours and Company, Wilmington, DE) may be used.

Glass window substrates may also be utilized with DLC coatings to change the surface characteristics, light absorbency and scratch resistance of the glass substrate. Glass may also be co-laminated with plastic, wherein the plastic side of the laminate is coated with DLC.

Although particular embodiments of the present invention have been described in the foregoing description, it will be understood by those skilled in the art that the invention is capable of numerous modifications, substitutions and rearrangements without departing from the spirit or essential attributes of the invention. Reference should be made to the appended claims, rather than to the foregoing specification, as indicating the scope of the invention.

## Claims

1. A process for producing an essentially colorless, clear low conjugation diamond-like carbon (DLC) coating, comprising:
(a) depositing a thin layer of DLC onto a substrate;
(b) contacting said deposited DLC with a reactive species capable of saturating the double bonds in said DLC to produce low conjugation DLC;
(c) depositing a thin layer of DLC onto the surface of said low conjugation DLC;
(d) contacting the DLC deposited in step (c) with a reactive species capable of saturating the double bonds in the DLC to produce low conjugation DLC; and
(e) repeating steps (c) and (d) until a coating of low conjugation DLC of the desired thickness has been produced.

2. The Process of Claim 1 wherein the thickness of each thin layer of DLC deposited is 0.1 µm or less.

3. The process of Claim 2 wherein the thickness of the low conjugation DLC coating is 10 µm or less.

4. A process for producing an essentially colorless, clear low conjugation diamond-like carbon (DLC) coating with a thickness of 0.1 µm or less, comprising:
(a) depositing a thin layer of DLC of the desired thickness, but less than 0.1 µm, onto a substrate; and
(b) contacting said deposited DLC with a reactive species capable of saturating the double bonds in said DLC to produce a coating of essentially colorless, clear low conjugation DLC.

5. The process as in Claim 3 or 4, wherein the reactive species is in a gaseous state.

6. The process of Claim 5 wherein the reactive species is an activated form of fluorine, chlorine, bromine or hydrogen.

7. The process as in Claims 1 or 4, wherein the substrate is selected from the group consisting of plastics, glass, or laminate combinations thereof.

8. The process as in Claims 1 or 4, wherein the DLC is deposited onto the substrate in a patterned manner to leave portions of the substrate uncoated.

9. The process as in Claims 1 or 4, wherein the DLC is deposited onto a substrate that has previously been coated with another material.

## Patentansprüche

1. Verfahren zur Herstellung einer Beschichtung aus im wesentlichen farblosem, durchsichtigem, konjugationsarmem diamantartigem Kohlenstoff (DLC), mit den folgenden Schritten:
(a) Aufbringen einer dünnen Schicht aus DLC auf ein Substrat;
(b) Inkontaktbringen des aufgebrachten DLC mit einer reaktiven Spezies, die imstande ist, die Doppelbindungen in dem DLC abzusättigen, um konjugationsarmen DLC zu erzeugen;
(c) Aufbringen einer dünnen DLC-Schicht auf die Oberfläche des konjugationsarmen DLC;
(d) Inkontaktbringen des im Schritt (c) aufgebrachten DLC mit einer reaktiven Spezies, die imstande ist, die Doppelbindungen in dem DLC abzusättigen, um konjugationsarmen DLC zu erzeugen; und
(e) Wiederholen der Schritte (c) und (d), bis eine Beschichtung aus konjugationsarmem DLC mit der gewünschten Dicke erzeugt worden ist.

2. Verfahren nach Anspruch 1, wobei die Dicke jeder aufgebrachten dünnen DLC-Schicht höchstens 0,1 µm beträgt.

3. Verfahren nach Anspruch 2, wobei die Dicke der Beschichtung aus konjugationsarmem DLC höchstens 10 µm beträgt.

4. Verfahren zur Herstellung einer Beschichtung aus im wesentlichen farblosem, durchsichtigem, konjugationsarmem diamantartigem Kohlenstoff (DLC) mit einer Dicke von höchstens 0,1 µm, mit den folgenden Schritten:
(a) Aufbringen einer dünnen Schicht aus DLC mit der gewünschten Dicke, die aber kleiner als 0,1 µm ist, auf ein Substrat; und
(b) Inkontaktbringen des aufgebrachten DLC mit einer reaktiven Spezies, die imstande ist, die Doppelbindungen in dem DLC abzusättigen, um eine Beschichtung aus im wesentlichen farblosem, durchsichtigem, konjugationsarmem DLC zu erzeugen.

5. Verfahren nach Anspruch 3 oder 4, wobei sich die reaktive Spezies in gasförmigem Zustand befindet.

6. Verfahren nach Anspruch 5, wobei die reaktive Spezies eine aktivierte Form von Fluor, Chlor, Brom oder Wasserstoff ist.

7. Verfahren nach einem der Ansprüche 1 oder 4, wobei das Substrat aus der Gruppe ausgewählt ist, die aus Kunststoffen, Glas oder Laminatkombinationen daraus besteht.

8. Verfahren nach einem der Ansprüche 1 oder 4, wobei der DLC strukturiert auf das Substrat aufgebracht wird, um Teile des Substrats unbeschichtet zu lassen.

9. Verfahren nach einem der Ansprüche 1 oder 4, wobei der DLC auf ein Substrat aufgebracht wird, das zuvor mit einem anderen Material beschichtet worden ist.

## Revendications

1. Procédé de production d'un revêtement de carbone semblable à du diamant (DLC) essentiellement incolore, faiblement conjugué et transparent, comprenant:
(a) le dépôt d'une couche mince de DLC sur un substrat;
(b) la mise en contact dudit DLC déposé avec une espèce réactive capable de saturer les doubles liaisons dans ledit DLC pour produire un DLC faiblement conjugué;
(c) le dépôt d'une couche mince de DLC sur la surface dudit DLC faiblement conjugué;
(d) la mise en contact du DLC déposé dans l'étape (c) avec une espèce réactive capable de saturer les doubles liaisons dans le DLC pour produire un DLC faiblement conjugué; et
(e) la répétition des étapes (c) et (d) jusqu'à ce qu'un revêtement de DLC faiblement conjugué ayant l'épaisseur désirée ait été produit.

2. Procédé de la revendication 1 dans lequel l'épaisseur de chaque couche mince de DLC déposée est de 0,1 µm ou moins.

3. Procédé de la revendication 2 dans lequel l'épaisseur du revêtement de DLC faiblement conjugué est de 10 µm ou moins.

4. Procédé de production d'un revêtement de carbone semblable à du diamant (DLC) essentiellement incolore, faiblement conjugué et transparent, ayant une épaisseur de 0,1 µm ou moins, comprenant:
(a) le dépôt d'une couche mince de DLC ayant l'épaisseur désirée, mais inférieure à 0,1 µm, sur un substrat; et
(b) la mise en contact dudit DLC déposé avec une espèce réactive capable de saturer les doubles liaisons dans ledit DLC pour produire un revêtement de DLC faiblement conjugué essentiellement incolore et transparent.

5. Procédé selon la revendication 3 ou 4, dans lequel l'espèce réactive est à l'état gazeux.

6. Procédé de la revendication 5 dans lequel l'espèce réactive est une forme activée de fluor, de chlore, de brome ou d'hydrogène.

7. Procédé selon les revendications 1 ou 4, dans lequel le substrat est choisi dans le groupe constitué des plastiques, du verre, ou de leurs combinaisons stratifiées.

8. Procédé selon les revendications 1 ou 4, dans lequel le DLC est déposé sur le substrat d'une manière structurée pour laisser des portions du substrat non revêtues.

9. Procédé selon les revendications 1 ou 4, dans lequel le DLC est déposé sur un substrat qui a été préalablement revêtu d'un autre matériau.
